# FASCICULE DE BREVET EUROPEEN

(11) **EP 3 018 781 B1**
(45) Date de publication et mention de la délivrance du brevet: **29.09.2021**
(21) Numéro de dépôt: 15192963.5
(22) Date de dépôt: 04.11.2015
(51) Int. Cl.: H02H 1/00, H02H 7/22

(54) **SYSTÈME ET PROCÉDÉ DE DÉTECTION ET DE PASSIVATION D'UN ARC ÉLECTRIQUE**
SYSTEM UND VERFAHREN ZUM ERFASSEN UND PASSIVIEREN EINES LICHTBOGENS
SYSTEM AND METHOD FOR DETECTING AND PASSIVATING AN ELECTRIC ARC

(30) Priorité: 06.11.2014 FR 1460722
(43) Date de publication de la demande: 11.05.2016
(73) Titulaire: Airbus SAS, 31700 Blagnac (FR); AIRBUS OPERATIONS (SAS), 31060 Toulouse (FR)
(72) Inventeur: TATRY, Philippe, 31130 BALMA (FR); DONADILLE, Christian, 31320 CASTANET TOLOSAN (FR)
(74) Mandataire: Brevalex

(56) Documents cités:
- EP-A2- 2 120 306
- EP-A2- 2 202 859
- WO-A1-2014/128263
- FR-A1- 2 827 675
- FR-A1- 2 925 987
- FR-A1- 2 977 677
- US-A1- 2006 164 097
- US-A1- 2014 063 662
- None

## Description

### DOMAINE TECHNIQUE

La présente invention concerne le domaine de détection d'un arc électrique et plus particulièrement, la détection et la passivation d'un arc électrique dans un dispositif électrique embarqué.

### ÉTAT DE LA TECHNIQUE ANTÉRIEURE

Un arc électrique peut être produit lorsque deux contacts conduisant initialement un courant électrique sont séparés. Une décharge électrique pouvant atteindre une température de 7000°C à 10000°C prend alors naissance dans l'espace entre les deux contacts et maintient la conduction électrique. L'apparition d'arcs électriques entretenus dans le temps au niveau d'éléments électriques de stockage, de distribution et/ou d'utilisation peut éventuellement entraîner des dégradations de ces éléments électriques et des équipements voisins.

Ainsi, afin de se prémunir contre les risques de propagation d'arcs électriques, il est important de détecter le début de tout arc électrique afin de couper le circuit électrique.

La détection d'un arc électrique est généralement basée sur la mesure de l'intensité électrique dans la ligne alimentant l'élément électrique. En effet, lors de l'apparition d'un arc électrique, l'intensité de courant augmente de façon significative pouvant dépasser plusieurs fois l'intensité de courant nominale.

Toutefois, pour être immune à des déclenchements intempestifs dus à des fausses alarmes, il est important de confirmer le défaut avant toute coupure du circuit ce qui requiert un délai de traitement ou de confirmation qui souvent n'est pas compatible avec la vitesse de propagation de l'arc électrique qui est de l'ordre de 100 mètres par seconde. Le délai de confirmation peut prendre quelques centaines de millisecondes voire même quelques secondes en fonction de l'intensité du courant et de la température. Ces délais sont bien supérieurs à ceux nécessaires pour couper l'arc électrique sans dommage et/ou sans contrainte forte sur les équipements.

Afin de résoudre ce genre de problèmes, on utilise des moyens d'isolation pour protéger les éléments et équipements électriques contre les risques de propagation d'arcs électriques pendant le délai de confirmation.

Systèmes de détection et protection contre l'arc électrique sont divulgués par exemple dans les documents US 2006/ 164097 et FR 2 925 987.

En particulier dans le domaine de l'aéronautique qui est dicté par des contraintes particulièrement sévères de sécurité et de fiabilité, les cœurs électriques et boîtiers de distribution électriques d'un aéronef sont protégés par plusieurs éléments d'isolation et de protection afin d'éviter la propagation d'éventuels arcs électriques entre les différents composants ou éléments électriques.

En effet, les bornes sur les éléments électriques bénéficient d'une double isolation comprenant des parois et rondelles en céramique et des traitements de surface spécifiques. A titre d'exemple, la double isolation sur un écrou de serrage conduit à traiter la surface de l'écrou en le recouvrant d'une matière isolante et à rajouter des rondelles isolantes avec des bords montants pour gêner le passage d'un arc électrique. De plus, des protections mécaniques telles que des grilles et/ou des capotages sont ajoutées afin de se prémunir contre des petites pièces métalliques extérieures ou des corps étrangers qui peuvent provoquer des courts-circuits.

Bien que très efficaces, ces types de protection présentent cependant quelques inconvénients. En particulier, ils compliquent l'installation et augmentent l'encombrement et la masse des boîtiers de distribution électriques. De plus, les grilles et autres protections mécaniques créent des contraintes thermiques en limitant les échanges de chaleur entre les dispositifs électriques et l'environnement extérieur.

L'objectif de la présente invention est par conséquent de proposer un système et un procédé de détection et de passivation d'un arc électrique simple à mettre en œuvre et qui est capable de détecter rapidement avec précision et fiabilité toute apparition d'un arc électrique dans un dispositif électrique et qui apporte une réponse rapide de passivation de l'arc électrique sans présenter les inconvénients précités.

### EXPOSÉ DE L'INVENTION

La présente invention est définie par les revendications 1 et 9, et consiste dans un système et un procédé de détection et de passivation d'un arc électrique sur au moins un élément de connexion d'un dispositif électrique, comportant :
- une chaîne d'acquisition acoustique configurée pour acquérir des signaux acoustiques émis par ledit élément de connexion,
- une chaîne d'acquisition électrique configurée pour acquérir des signaux électriques représentatifs des intensités de courant électrique alimentant ledit élément de connexion, et
- un corrélateur couplé auxdites chaînes d'acquisition acoustique et électrique et configuré pour évaluer une corrélation entre les signaux acoustiques et les signaux électriques et pour déclencher un signal de coupure adapté pour couper un circuit électrique relatif audit élément de connexion lorsque ladite corrélation est représentative d'un début d'arc électrique.

Le système de la présente invention permet de détecter en temps quasi-réel, de manière fiable, et avec un temps de calcul minimal, toute amorce d'un arc électrique dans l'élément de connexion d'un dispositif électrique et d'isoler rapidement l'élément de connexion défaillant. Plus particulièrement, ce système permet de minimiser les contraintes d'installation et d'isolation tout en permettant une très grande disponibilité du dispositif électrique.

### BRÈVE DESCRIPTION DES DESSINS

D'autres caractéristiques et avantages de l'invention apparaîtront à la lecture de modes de réalisation préférentiels de l'invention faits en référence aux figures jointes parmi lesquelles :
La Fig. 1 illustre de manière schématique un procédé et un système de détection et de passivation d'un arc électrique dans un dispositif électrique, selon un mode de réalisation de l'invention ;
La Fig. 2 illustre de manière schématique un système de détection, selon un mode de réalisation préféré de l'invention ; et
La Fig. 3 illustre de manière schématique un procédé de détection d'un arc électrique dans un dispositif électrique selon le système de détection de la Fig. 2.

### EXPOSÉ DÉTAILLÉ DE MODES DE RÉALISATION PARTICULIERS

Le concept à la base de l'invention repose sur l'évaluation d'une corrélation entre deux grandeurs physiques distinctes (intensité de courant et onde acoustique) permettant de détecter rapidement et de manière fiable l'amorce d'un arc électrique dans un dispositif électrique.

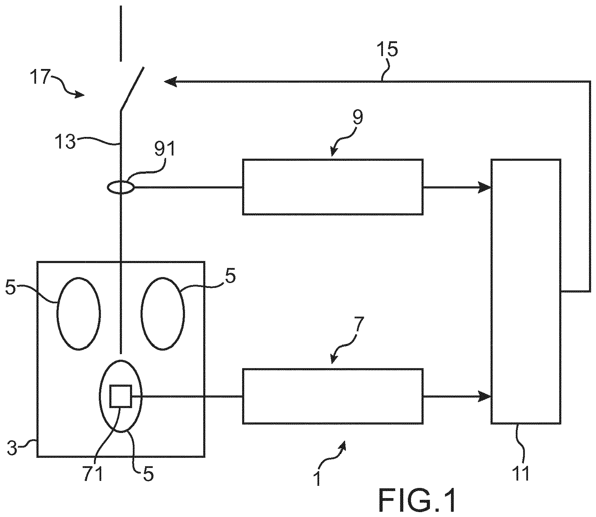

La Fig. 1 illustre de manière schématique un procédé et un système 1 de détection et de passivation d'un arc électrique dans un dispositif électrique 3, selon un mode de réalisation de l'invention.

Le dispositif électrique 3 est par exemple un boitier de distribution électrique comportant des composants de puissance et un ensemble d'au moins un élément électrique de connexion 5.

Le système 1 de détection et de passivation (désigné ci-après système de détection) est mis en œuvre par des capteurs et cartes électroniques d'acquisition, de traitement et de commande, comprenant une chaîne d'acquisition acoustique 7, une chaîne d'acquisition électrique 9 et un corrélateur 11.

La chaîne d'acquisition acoustique 7 est configurée pour acquérir des signaux acoustiques émis par chaque élément de connexion 5. En particulier, la chaîne d'acquisition acoustique 7 comporte des capteurs acoustiques 71 adaptés pour capter les ondes acoustiques émises aux niveaux des éléments de connexion 5. Chaque capteur acoustique 71 est installé dans une zone allouée à un élément de connexion 5 correspondant et peut être constitué d'un ou de plusieurs transducteurs ultrasoniques (ou microphones) dans une bande allant de quelques dizaines de kHz à quelques centaines de kHz.

La chaîne d'acquisition électrique 9 est configurée pour acquérir des signaux électriques représentatifs des intensités de courant électrique alimentant chaque élément de connexion 5. En particulier, au moins un capteur 91 ou appareil de mesure de l'intensité de courant est branché dans la ligne d'alimentation électrique 13 alimentant l'élément de connexion 5 correspondant. On notera que chaque ligne d'alimentation 13 peut être multiphasique et alors, l'intensité de courant est mesurée dans chaque ligne de phase.

Le corrélateur 11 est couplé aux chaînes d'acquisition acoustique 7 et électrique 9 et est configuré pour évaluer une corrélation entre les signaux acoustiques et les signaux électriques. En outre, le corrélateur 11 est configuré pour déclencher un signal de coupure (flèche 15) adapté pour couper le circuit électrique 17 relatif à l'élément de connexion 5 lorsque la corrélation est représentative d'un début d'arc électrique au niveau de cet élément 5. Plus particulièrement, lorsqu'une corrélation est établie entre une surintensité électrique représentative d'une amorce d'un arc électrique et une onde acoustique également représentative d'une amorce d'un arc électrique au niveau d'un élément de connexion 5, le corrélateur 11 déclenche immédiatement la coupure de la ligne d'alimentation 13 alimentant cet élément de connexion 5 sans aucune période de confirmation. En effet, lorsqu'une corrélation est confirmée entre deux grandeurs physiques complètement distinctes et représentatives d'un début d'arc électrique, il est vraisemblable avec une grande probabilité que le début d'arc électrique est bien réel et non pas une fausse alarme. Ainsi, l'élément de connexion 5 défectueux est isolé quasiment en temps réel des autres éléments du dispositif électrique 3 et par conséquent, l'arc électrique est passivé avant qu'une propagation d'arc électrique puisse atteindre le voisinage de l'élément de connexion 5 défectueux.

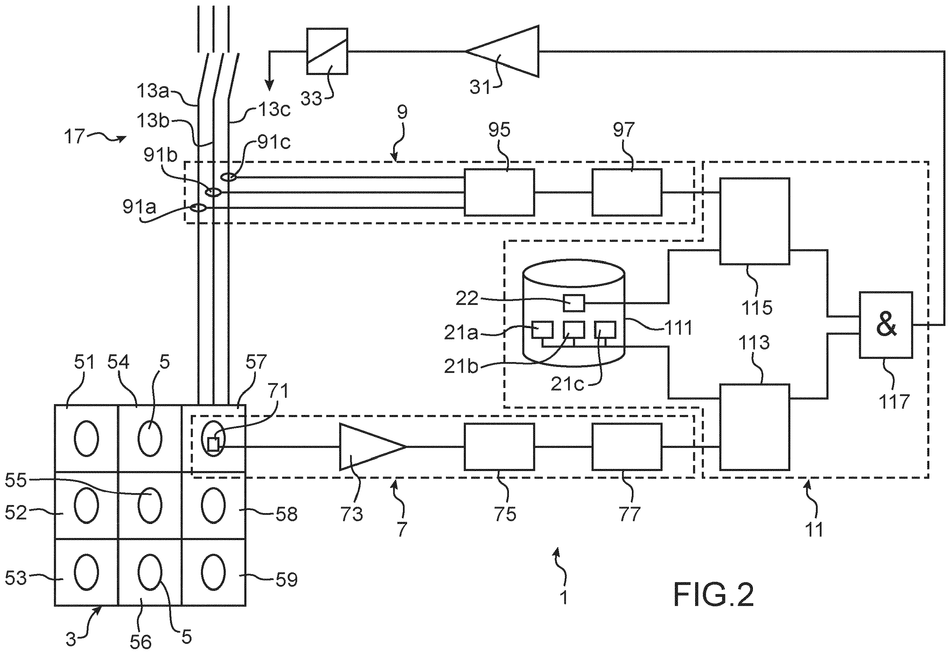

La Fig. 2 illustre de manière schématique un système de détection, selon un mode de réalisation préféré de l'invention.

Selon cet exemple, le dispositif électrique 3 est une armoire ou boitier de distribution électrique embarqué comportant un ensemble d'éléments de connexion 5 agencés dans des compartiments 51-59 correspondants. Ce boitier de distribution électrique 3 est par exemple compris dans le cœur électrique de puissance d'un aéronef. Chaque compartiment 51-59 comporte une alvéole correspondant à une zone fonctionnelle spécifique. Les alvéoles sont physiquement des volumes préférentiellement fermés de façon que seules les barres d'alimentation des éléments de connexion ou quelques connecteurs traversent leurs parois. Chaque élément de connexion 5 est alimenté par une ligne d'alimentation 13 comprenant un ensemble de lignes de phase 13a, 13b, 13c. Une seule ligne d'alimentation 13 alimentant un seul élément de connexion 5 est représenté. Plus particulièrement et par souci de simplification, seuls les moyens (i.e. ligne d'alimentation 13, chaînes d'acquisitions acoustique 7 et électrique 9 et corrélateur 11) correspondant à un seul élément de connexion 5 du compartiment 57 sont représentés sur le schéma de la Fig. 2.

La chaîne d'acquisition acoustique 7 comporte un capteur acoustique 71, un amplificateur 73, un premier conditionneur 75 et un premier filtre 77.

Le capteur acoustique 71 est installé dans l'alvéole (ou la zone) allouée à l'élément de connexion 5. Le confinement alvéolaire rend le capteur acoustique 71 insensible aux bruits venant de l'extérieur de l'alvéole et lui permet ainsi de capter les signaux acoustiques émis par l'élément de connexion 5 avec une grande précision non entachée d'erreurs de bruits extérieurs. Avantageusement, le capteur 71 est composé d'un ou de plusieurs transducteurs ultrasoniques par exemple à base de MEMS (Micro Electro-Mechanical System).

L'amplificateur 73 de signal acoustique est connecté au capteur acoustique 71 et est configuré pour amplifier les signaux acoustiques reçus depuis ce capteur acoustique 71.

Le premier conditionneur 75 est connecté à l'amplificateur 73 et est configuré pour formater les signaux acoustiques. En effet, les signaux acoustiques sont mis en forme pour être traités par le premier filtre 77. Ce dernier est connecté au conditionneur 75 et est configuré pour filtrer les signaux acoustiques à la sortie de ce conditionneur 75. Le premier filtre 77 permet par exemple d'éliminer les données isolées ou aberrantes éventuellement présentes dans les signaux acoustiques qui peuvent être dus par exemple, à des erreurs aléatoires.

La chaîne d'acquisition électrique 9 comporte des capteurs d'intensité électrique 91a-91c, un deuxième conditionneur 95 et un deuxième filtre 97.

Les capteurs d'intensité électrique 91a-91c sont installés dans la ligne d'alimentation 13 de l'élément de connexion 5. En particulier, un capteur d'intensité électrique est branché dans chaque ligne de phase 13a, 13b, 13c pour capter les signaux électriques représentatifs des intensités de courant électrique alimentant l'élément de connexion 5.

Le deuxième conditionneur 95 est connecté aux capteurs d'intensité électrique 91a-91c et est configuré pour formater les signaux électriques.

En outre, le deuxième filtre 97 est connecté au deuxième conditionneur 95 et est configuré pour filtrer les signaux électriques à la sortie de ce conditionneur 95.

Par ailleurs, le corrélateur 11 comporte une mémoire 111, un comparateur acoustique 113, un comparateur électrique 115, et un déclencheur de coupure 117.

La mémoire 111 est adaptée pour stocker au moins une signature acoustique de référence 21a qui est caractéristique d'un arc électrique et au moins une signature électrique 22 de référence qui est également caractéristique d'un arc électrique.

Selon la présente invention, la mémoire 111 comporte un ensemble de signatures acoustiques 21a-21c de référence, chacune étant définie en fonction du contexte environnemental de l'élément de connexion 5. En particulier, chaque signature acoustique 21a-21c de référence est définie en fonction de la pression au niveau de l'élément de connexion 5 sachant que dans le cas d'un aéronef, la pression dépend de l'altitude. Un catalogue ou un ensemble prédéterminé de signatures acoustiques 21a-21c de référence représentant des arcs électriques selon différentes altitudes de l'aéronef peut être préenregistré dans la mémoire 111.

L'ensemble de signatures acoustiques 21a-21c de référence est construit préalablement à partir d'un modèle de détection d'arcs électriques selon la pression ou l'altitude en utilisant des courbes de Paschen et/ou des essais sur banc. Ainsi, on prend en compte les effets de la pression et par conséquent, de l'altitude sur l'acoustique de l'arc électrique et sur son occurrence. Avantageusement, ces signatures acoustiques sont obtenues d'abord par calculs, puis affinées par les essais.

Le comparateur acoustique 113 est connecté à la chaîne d'acquisition acoustique 7 et est configuré pour comparer les signaux acoustiques à la ou les signature(s) acoustique(s) 21a-21c de référence afin de vérifier si les signaux acoustiques sont indicateurs d'une apparition d'un arc électrique.

Plus particulièrement, le comparateur acoustique 113 est adapté pour vérifier si les signaux acoustiques sont indicateurs d'une apparition d'un arc électrique en calculant des coefficients de corrélation normalisés entre les signaux acoustiques et une signature acoustique de référence et en comparant les coefficients de corrélation à un seuil acoustique prédéterminé qui correspond à un seuil de sensibilité par rapport à un risque de fausse alarme. Ainsi, si un coefficient de corrélation dépasse le seuil acoustique prédéterminé alors, les signaux acoustiques sont considérés comme indicateurs de l'apparition d'un arc électrique.

Avantageusement, le comparateur acoustique 113 utilise une analyse par traitement vectoriel des signaux acoustiques ou par un filtrage adapté à un apprentissage des signaux d'arcs électriques. En effet, un modèle robuste et suffisamment générique de type ARMA (Auto Régressive Moving Average) peut être utilisé pour s'adapter à la variabilité des types de signatures acoustiques générées par les arcs électriques. Le modèle ARMA est un modèle autorégressif et de moyenne mobile qu'on peut appliquer sur les signaux acoustiques mesurés en utilisant une fenêtre temporelle glissante. Le modèle ARMA permet d'évaluer l'erreur quadratique moyenne de la signature de référence par rapport aux signaux réellement mesurés lors d'un arc électrique.

Par ailleurs, le comparateur électrique 115 est connecté à la chaîne d'acquisition électrique 9 et est configuré pour comparer les signaux électriques à la ou les signature(s) électrique(s) 22 de référence afin de vérifier si les signaux électriques sont indicateurs d'une apparition d'un arc électrique. En particulier, lorsqu'une surintensité dépasse un seuil de détection électrique d'environ deux fois le courant nominal entre les lignes de phase 13a-13c, les signaux électriques sont considérés comme indicateurs d'une apparition d'un arc électrique entre ces phases. De même, lorsque l'intensité de courant est comprise entre quelques dizaines de milliampères (mA) et quelques ampères (A), les signaux électriques sont considérés comme indicateurs d'une apparition d'un arc électrique entre la partie active et la structure et/ou la masse de l'élément de connexion 5.

Le déclencheur de coupure 117 est connecté aux comparateurs acoustique 113 et électrique 115 et est configuré pour déclencher un signal de coupure 15 si les signaux acoustiques sont indicateurs d'un arc électrique et les signaux électriques sont également indicateurs d'un arc électrique.

En outre, le système de détection 1 comporte un amplificateur de commande 31 et un organe de coupure électrique 33 connecté à l'amplificateur de commande 31.

L'amplificateur de commande 31 est configuré pour amplifier le signal de coupure 15 afin de commander la coupure du circuit électrique 17 relatif au compartiment 57 présentant un arc électrique.

L'organe de coupure électrique 33 (comportant par exemple des relais, des interrupteurs électroniques, ou des interrupteurs électromécaniques) est configuré pour couper le circuit électrique 17 de l'élément de connexion 5 lorsqu'il reçoit le signal de coupure 15 depuis l'amplificateur de commande 31.

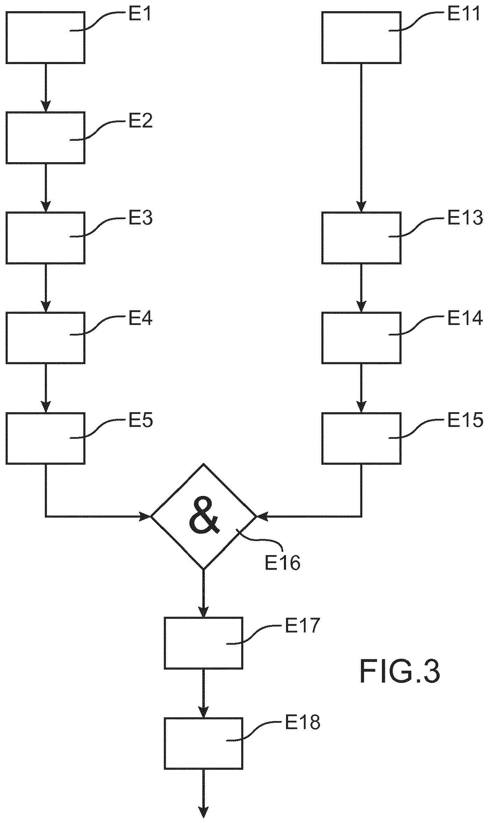

La Fig. 3 illustre de manière schématique un procédé de détection d'un arc électrique sur un dispositif électrique selon le système de détection de la Fig. 2.

Les étapes E1 à E5 et E11 à E15 sont réalisées simultanément.

A l'étape E1, un capteur acoustique 71 détecte dans un compartiment 57 d'un élément de connexion 5 un bruit ou des signaux acoustiques pouvant être liés à l'apparition d'un arc électrique.

A l'étape E2, l'amplificateur acoustique 73 amplifie les signaux acoustiques qui sont ensuite conditionnés à l'étape E3 par le premier conditionneur 75 et filtrés à l'étape E4 par le premier filtre 77.

A l'étape E5, le comparateur acoustique 113 utilise une fenêtre temporelle glissante pour moyenner de manière mobile (selon le modèle ARMA) les signaux acoustiques reçus successivement depuis le premier filtre 77 formant ainsi une succession de signaux acoustiques moyens.

Ensuite, le comparateur acoustique 113 compare chaque signal acoustique moyen à au moins une signature acoustique 21a prédéterminée sélectionnée parmi l'ensemble de signatures acoustiques 21a-21c de référence correspondant chacune à une signature représentative d'un arc électrique en fonction de la pression ou de l'altitude de l'aéronef.

Autrement dit, on utilise l'altitude de l'aéronef comme un paramètre de sélection pour choisir comme signature acoustique, celle correspondant à l'attitude courante de l'aéronef. Le comparateur acoustique 113 compare ensuite chaque signal acoustique moyen à la signature acoustique sélectionnée 21a.

Avantageusement, le comparateur acoustique 113 réalise la comparaison en calculant un produit de convolution normalisé entre le signal acoustique moyen relatif à l'élément de connexion 5 et la signature acoustique sélectionnée 21a. Le score normalisé du produit de convolution indique alors l'existence ou la non existence d'une corrélation entre le signal acoustique moyen (représentatif du bruit émis par l'élément de connexion) et la signature acoustique sélectionnée 21a représentative d'un arc électrique. En particulier, le comparateur acoustique 113 compare chacun des scores normalisés au seuil acoustique prédéterminé afin d'attester la détection d'un arc électrique au cas où au moins un score dépasse ce seuil acoustique. On notera que le seuil acoustique peut être réglé par expérimentation et/ou par retour d'expérience pour éviter toute fausse alarme.

En parallèle, à l'étape E11, les capteurs électriques 91a-91c mesurent les intensités de courant alimentant les éléments de connexion 5. Les signaux électriques reçus des capteurs 91a-91c sont conditionnés à l'étape E13 par le deuxième conditionneur 95 avant d'être filtrés à l'étape E14 par le deuxième filtre 97.

A l'étape E15, le comparateur électrique 115 compare les signaux électriques à la ou les signature(s) électrique(s) 22 de référence afin de vérifier si les signaux électriques sont indicateurs d'une apparition d'un arc électrique. En particulier, lorsque des signaux électriques relatifs à un élément de connexion 5 présentent une surintensité (i.e. dépassent le seuil de détection électrique), alors, ces signaux sont considérés comme indicateurs d'une apparition d'un arc électrique.

A l'étape E16 si un même élément de connexion 5 présente des signaux acoustiques indicateurs d'un arc électrique et des signaux électriques également indicateurs d'un arc électrique, alors le déclencheur de coupure 117 génère un signal de coupure 15.

A l'étape E17, l'amplificateur de commande 31 amplifie le signal de coupure et à l'étape E18 l'organe de coupure 33 électrique coupe le circuit électrique 17 en amont de l'élément de connexion 5 présentant l'arc électrique.

Ainsi, le procédé et le système de détection selon la présente invention permet de détecter et de couper l'arc électrique de manière fiable et rapide dans par exemple des cœurs électriques et les boitiers de distribution de puissance d'un aéronef. En effet, la corrélation de deux grandeurs physiques distinctes (i.e., courant électrique et onde acoustique avec référencement à des signatures d'arcs électriques) permet de statuer en temps réel et avec fiabilité le début d'un arc électrique sans la nécessité d'avoir un délai de confirmation.

Grâce à une isolation rapide de la zone présentant un arc électrique, les contraintes d'installation et d'isolation pour la conception des boitiers de distribution seront minimisées permettant ainsi des gains significatifs en coût et en masse.

De plus, la protection par zone présente l'avantage de n'isoler que la partie en défaut et elle permet ainsi une plus grande disponibilité et flexibilité de distribution et donc des équipements alimentés.

## Revendications

1. Système de détection et de passivation d'un arc électrique sur au moins un élément de connexion (5) d'un dispositif électrique (3), comportant:
- une chaîne d'acquisition acoustique (7) configurée pour acquérir des signaux acoustiques émis par ledit élément de connexion (5),
- une chaîne d'acquisition électrique (9) configurée pour acquérir des signaux électriques représentatifs des intensités de courant électrique alimentant ledit élément de connexion (5), et
- un corrélateur (11) couplé auxdites chaînes d'acquisition acoustique (7) et électrique (9) et configuré pour évaluer une corrélation entre les signaux acoustiques et les signaux électriques et pour déclencher un signal de coupure (15) adapté pour couper un circuit électrique (17) relatif audit élément de connexion (5) lorsque ladite corrélation est représentative d'un début d'arc électrique, le système **caractérisé en ce que** ledit corrélateur comporte :
- une mémoire (111) stockant au moins une signature acoustique (21a-21c) d'un arc électrique et au moins une signature électrique (22) d'un arc électrique, ladite mémoire (111) étant adaptée pour stocker un ensemble de signatures acoustiques (21a-21c), chacune étant définie en fonction de la pression atmosphérique au niveau dudit élément de connexion,
- un comparateur acoustique (113) connecté à ladite chaîne d'acquisition acoustique (7) et configuré pour comparer les signaux acoustiques à ladite au moins une signature acoustique afin de vérifier si les signaux acoustiques sont indicateurs d'une apparition d'un arc électrique,
- un comparateur électrique (115) connecté à ladite chaîne d'acquisition électrique (9) et configuré pour comparer les signaux électriques à ladite au moins une signature électrique afin de vérifier si les signaux électriques sont indicateurs d'une apparition d'un arc électrique, et
- un déclencheur (117) de coupure connecté auxdits comparateurs acoustique (113) et électrique (115) et configuré pour déclencher le signal de coupure si les signaux acoustiques sont indicateurs d'un arc électrique et les signaux électriques sont également indicateurs d'un arc électrique.

2. Système selon la revendication 1 **caractérisé en ce que** chaque signature acoustique est définie en fonction de l'altitude dudit élément de connexion, dans le cas où la pression dépend de l'altitude.

3. Système selon l'une quelconque des revendications 1 à 2 **caractérisé en ce que** le comparateur acoustique (113) est configuré pour moyenner les signaux acoustiques selon un modèle de moyenne mobile avant la comparaison à ladite au moins une signature acoustique de référence.

4. Système selon l'une quelconque des revendications précédentes, **caractérisé en ce que** la chaîne d'acquisition acoustique (7) comporte :
- un capteur acoustique (71) installé dans une zone allouée à l'élément de connexion (5) et configuré pour capter les signaux acoustiques émis par ledit élément de connexion,
- un amplificateur de signal acoustique (73) configuré pour amplifier les signaux acoustiques reçus depuis ledit au moins un capteur acoustique,
- un premier conditionneur (75) configuré pour formater les signaux acoustiques,
et
- un premier filtre (77) configuré pour filtrer les signaux acoustiques à la sortie dudit conditionneur.

5. Système selon l'une quelconque des revendications précédentes, **caractérisé en ce que** la chaîne d'acquisition électrique comporte :
- au moins un capteur d'intensité électrique (91) installé dans une ligne d'alimentation (13) dudit élément de connexion et configurée pour capter les signaux électriques représentatifs des intensités de courant électriques alimentant ledit élément de connexion,
- un deuxième conditionneur (95) configuré pour formater les signaux électriques, et
- un deuxième filtre (97) configuré pour filtrer les signaux électriques à la sortie dudit conditionneur.

6. Système selon l'une quelconque des revendications précédentes, **caractérisé en ce qu'**il comporte en outre :
- un amplificateur de commande (31) configuré pour amplifier ledit signal de coupure (15) afin de commander la coupure dudit circuit électrique relatif audit élément de connexion, et
- un organe de coupure (33) électrique configuré pour couper ledit circuit électrique (17) lorsqu'il reçoit ledit signal de coupure depuis l'amplificateur de commande.

7. Système selon l'une quelconque des revendications précédentes, **caractérisé en ce que** ledit dispositif électrique (3) est un boitier de distribution électrique embarqué comportant un ensemble d'éléments de connexions agencés dans des compartiments correspondants, chaque élément de connexion étant alimenté par une ligne d'alimentation (13) comprenant un ensemble de lignes de phase (13a-13c).

8. Aéronef comportant un boitier de distribution électrique (3) et un système de détection (1) d'un arc électrique dans ledit boitier de distribution électrique selon l'une quelconque des revendications précédentes.

9. Procédé de détection et de passivation d'un arc électrique sur au moins un élément de connexion d'un dispositif électrique, comportant les étapes suivantes :
- acquisition des signaux acoustiques émis par ledit élément de connexion,
- acquisition des signaux électriques représentatifs des intensités de courant électrique alimentant ledit élément de connexion, et caractérisé dans les étapes suivantes:
- comparaison desdits signaux acoustiques à au moins une signature acoustique parm un ensemble de signatures acoustiques (21a 21c) afin de vérifier si les signaux acoustiques sont indicateurs d'une apparition d'un arc électrique, chaque signature acoustique étant définie en fonction de la pression atmosphérique au niveau dudit élément de connexion.
- comparaison desdits signaux électriques à au moins une signature électrique afin de vérifier si les signaux électriques sont indicateurs d'une apparition d'un arc électrique, et
- déclenchement d'un signal de coupure adapté pour couper un circuit électrique relatif audit élément de connexion lorsque les signaux acoustiques sont indicateurs d'un arc électrique et les signaux électriques sont également indicateurs d'un arc électrique.

## Patentansprüche

1. System zur Erfassung und Passivierung eines Lichtbogens auf mindestens einem Verbindungselement (5) einer elektrischen Vorrichtung (3), das aufweist:
- eine akustische Erfassungskette (7), die konfiguriert ist, vom Verbindungselement (5) gesendete akustische Signale zu erfassen,
- eine elektrische Erfassungskette (9), die konfiguriert ist, elektrische Signale zu erfassen, die für die elektrischen Stromstärken repräsentativ sind, die das Verbindungselement (5) versorgen, und
- einen Korrelator (11), der mit den akustischen (7) und elektrischen (9) Erfassungsketten gekoppelt und konfiguriert ist, eine Korrelation zwischen den akustischen Signalen und den elektrischen Signalen zu bewerten und ein Abschaltsignal (15) auszulösen, das geeignet ist, eine elektrische Schaltung (17) betreffend das Verbindungselement (5) abzuschalten, wenn die Korrelation für einen Beginn eines Lichtbogens repräsentativ ist,
wobei das System **dadurch gekennzeichnet ist, dass** der Korrelator aufweist:
- einen Speicher (111), der mindestens eine akustische Signatur (21a-21c) eines Lichtbogens und mindestens eine elektrische Signatur (22) eines Lichtbogens speichert, wobei der Speicher (111) geeignet ist, eine Einheit von akustischen Signaturen (21a-21c) zu speichern, die je abhängig vom Atmosphärendruck im Bereich des Verbindungselements definiert werden,
- einen akustischen Komparator (113), der mit der akustischen Erfassungskette (7) verbunden und konfiguriert ist, die akustischen Signale mit der mindestens einen akustischen Signatur zu vergleichen, um zu überprüfen, ob die akustischen Signale das Auftreten eines Lichtbogens anzeigen,
- einen elektrischen Komparator (115), der mit der elektrischen Erfassungskette (9) verbunden und konfiguriert ist, die elektrischen Signale mit der mindestens einen elektrischen Signatur zu vergleichen, um zu überprüfen, ob die elektrischen Signale das Auftreten eines Lichtbogens anzeigen, und
- einen Abschaltungsauslöser (117), der mit den akustischen (113) und elektrischen (115) Komparatoren verbunden und konfiguriert ist, das Abschaltsignal auszulösen, wenn die akustischen Signale einen Lichtbogen anzeigen und die elektrischen Signale ebenfalls einen Lichtbogen anzeigen.

2. System nach Anspruch 1 **dadurch gekennzeichnet, dass** jede akustische Signatur in dem Fall, in dem der Druck von der Höhe abhängt, abhängig von der Höhe des Verbindungselements definiert wird.

3. System nach einem der Ansprüche 1 bis 2, **dadurch gekennzeichnet, dass** der akustische Komparator (113) konfiguriert ist, vor dem Vergleich mit der mindestens einen akustischen Bezugssignatur die akustischen Signale gemäß einem mobilen Mittelwertmodell zu mitteln.

4. System nach einem der vorhergehenden Ansprüche, **dadurch gekennzeichnet, dass** die akustische Erfassungskette (7) aufweist:
- einen akustischen Sensor (71), der in einer dem Verbindungselement (5) zugeteilten Zone installiert und konfiguriert ist, die vom Verbindungselement gesendeten akustischen Signale aufzufangen,
- einen akustischen Signalverstärker (73), der konfiguriert ist, die vom mindestens einen akustischen Sensor empfangenen akustischen Signale zu verstärken,
- einen ersten Aufbereiter (75), der konfiguriert ist, die akustischen Signale zu formatieren, und
- einen ersten Filter (77), der konfiguriert ist, die akustischen Signale am Ausgang des Aufbereiters zu filtern.

5. System nach einem der vorhergehenden Ansprüche, **dadurch gekennzeichnet, dass** die elektrische Erfassungskette aufweist:
- mindestens einen Stromstärkensensor (91), der in einer Versorgungsleitung (13) des Verbindungselement installiert und konfiguriert ist, die elektrischen Signale aufzufangen, die für die elektrische Stromstärken repräsentativ sind, die das Verbindungselement versorgen,
- einen zweiten Aufbereiter (95), der konfiguriert ist, die elektrischen Signale zu formatieren, und
- einen zweiten Filter (97), der konfiguriert ist, die elektrischen Signale am Ausgang des Aufbereiters zu filtern.

6. System nach einem der vorhergehenden Ansprüche, **dadurch gekennzeichnet, dass** es außerdem aufweist:
- einen Steuerverstärker (31), der konfiguriert ist, das Abschaltsignal (15) zu verstärken, um das Abschalten der elektrischen Schaltung betreffend das Verbindungselement zu steuern, und
- ein elektrisches Abschaltorgan (33), das konfiguriert ist, die elektrische Schaltung (17) abzuschalten, wenn es das Abschaltsignal vom Steuerverstärker empfängt.

7. System nach einem der vorhergehenden Ansprüche, **dadurch gekennzeichnet, dass** die elektrische Vorrichtung (3) ein bordeigener elektrischer Verteilerkasten ist, der eine Einheit von Verbindungselementen aufweist, die in entsprechenden Abteilen eingerichtet sind, wobei jedes Verbindungselement von einer Versorgungsleitung (13) versorgt wird, die eine Einheit von Phasenleitungen (13a-13c) enthält.

8. Luftfahrzeug, das einen elektrischen Verteilerkasten (3) und ein Erfassungssystem (1) eines Lichtbogens im elektrischen Verteilerkasten nach einem der vorhergehenden Ansprüche aufweist.

9. Verfahren zur Erfassung und zur Passivierung eines Lichtbogens auf mindestens einem Verbindungselement einer elektrische Vorrichtung, das die folgenden Schritte aufweist:
- Erfassung der vom Verbindungselement gesendeten akustischen Signale,
- Erfassung der elektrischen Signale, die für die elektrischen Stromstärken repräsentativ sind, die das Verbindungselement versorgen,
und gekennzeichnet in den folgenden Schritten:
- Vergleich der akustischen Signale mit mindestens einer akustischen Signatur unter einer Einheit von akustischen Signaturen (21a, 21c), um zu überprüfen, ob die akustischen Signale einen Auftritt eines Lichtbogens anzeigen, wobei jede akustische Signatur abhängig vom Atmosphärendruck im Bereich des Verbindungselements definiert wird,
- Vergleich der elektrischen Signale mit mindestens einer elektrischen Signatur, um zu überprüfen, ob die elektrischen Signale den Auftritt eines Lichtbogens anzeigen, und
- Auslösen eines Abschaltsignals, das geeignet ist, eine elektrische Schaltung betreffend das Verbindungselement abzuschalten, wenn die akustischen Signale einen Lichtbogen anzeigen und die elektrischen Signale ebenfalls einen Lichtbogen anzeigen.

## Claims

1. A system for the detection and passivation of an electric arc on at least one connecting element (5) of an electrical device (3), comprising:
an acoustic acquisition channel (7) configured for the acquisition of acoustic signals emitted by said connecting element (5),
an electric acquisition channel (9) configured for the acquisition of electric signals which are representative of the electric current intensities supplying said connecting element (5), and
a correlator (11) coupled to said acoustic and electric acquisition channels (7), configured for the evaluation of a correlation between the acoustic and electric signals and for the tripping of an appropriate cut-off signal (15) for the interruption of an electric circuit (17) relative to said connecting element (5), where said correlation is representative of the initiation of an electric arc, the system being **characterized in that** said correlator comprises:
a memory (111) for the storage of at least one acoustic signature (21a-21c) for an electric arc and at least one electric signature (22) for an electric arc, said memory being designed for the storage of a series of acoustic signatures, each of said acoustic signatures being defined as a function of the atmospheric pressure at said connecting element,
an acoustic comparator (113) connected to said acoustic acquisition (7) channel, configured for the comparison of acoustic signals with said at least one acoustic signature, in order to confirm whether the acoustic signals are indicative of the occurrence of an electric arc,
an electric comparator (115) connected to said electric acquisition channel (9) and configured for the comparison of electric signals with said at least one electric signature, in order to confirm whether said electric signals are indicative of the occurrence of an electric arc, and
a cut-off tripping device (117) coupled to said acoustic (113) and electric (115) comparators, and configured for the tripping of the cut-off signal if the acoustic signals are indicative of an electric arc and the electric signals are also indicative of an electric arc.

2. The system according to claim 1, wherein each acoustic signature is defined as a function of the altitude of said connecting element in the case where pressure depends on altitude.

3. The system according to claim 1 or 2, wherein the acoustic comparator (113) is configured for the averaging of acoustic signals in accordance with a moving average model, prior to comparison with said at least one acoustic reference signature.

4. The system according to anyone of the precedent claims, wherein the acoustic acquisition channel (7) comprises:
an acoustic sensor (71) installed in a zone allocated to the connecting element (5) and configured for the capture of acoustic signals emitted by said connecting element,
an acoustic signal amplifier (73) configured for the amplification of acoustic signals received from said at least one acoustic sensor,
a first conditioner (75) configured for the formatting of acoustic signals, and
a first filter (77) configured for the filtering of acoustic signals at the output of said conditioner.

5. The system according to anyone of the precedent claims, wherein the electric acquisition channel comprises:
at least one electric current intensity sensor (91) installed in a supply line (13) of said connecting element and configured for the capture of electric signals which are representative of the electric current intensities supplying said connecting element,
a second conditioner (95) configured for the formatting of electric signals, and
a second filter (97) configured for the filtering of electric signals at the output of said conditioner.

6. The system according to anyone of the precedent claims, further comprising:
a control amplifier (31) configured for the amplification of said cut-off signal (15) in order to actuate the interruption of said electric circuit relative to said connecting element, and
an electrical switching device (33) configured for the interruption of said electric circuit (17) upon the reception of said cut-off signal from the control amplifier.

7. The system according to anyone to the precedent claims, wherein said electrical device (3) is an on-board electrical distribution box comprising a series of connecting elements arranged in corresponding compartments, wherein each connecting element is supplied by a supply line (13) comprising a combination of phase lines (13a-13c).

8. An aircraft comprising
an electrical distribution box (3) and
a detection system (1) system for the detection of an electric arc in said distribution box according to anyone of the precedent claims.

9. A method for the detection and passivation of an electric arc on at least one connecting element of an electrical device, comprising the following steps:
acquiring acoustic signals emitted by said connecting element,
acquiring electric signals representative of the intensity of electric current supplying said connecting element,
and **characterized by** the following steps:
comparing said acoustic signals with at least one acoustic signature among a series of accoustic signals (21a-21c) in order to confirm whether said acoustic signals are indicative of the occurrence of an electric arc, each acoustic signature being defined as function of the atmospheric pressure at said connecting element,
comparing said electric signals with at least one electric signature in order to confirm whether the electric signals are indicative of the occurrence of an electric arc, and
tripping an appropriate cut-off signal for the interruption of an electric circuit relative to said connecting element, where the acoustic signals are indicative of an electric arc and the electric signals are also indicative of an electric arc.
